# EUROPEAN PATENT APPLICATION

(11) **EP 2 113 584 A1**
(43) Date of publication of application: **04.11.2009**
(21) Application number: 08155286.1
(22) Date of filing: 28.04.2008
(51) Int. Cl.: C23C 14/30, H01J 9/02

(54) **Evaporation system**

(71) Applicant: LightLab Sweden AB, 133 33 Saltsjöbaden (SE)
(72) Inventor: Hu, Qiu-Hong, 413 14 Göteborg (SE)
(74) Representative: Edlund, Fabian

(57) **Abstract**

The present invention relates to an evaporation system, comprising a vacuum chamber (102), a crucible (104) for receiving an evaporation material, a substrate holder (112) for receiving a substrate (114), and an electron beam source (116) for heating the evaporation material to be deposited on the substrate, wherein the electron beam source together with the crucible and the substrate holder are arranged inside of the vacuum chamber, the electron beam source is a field emission electron beam source, and the evaporation system further comprises a control unit (118) for controlling the direction of electrons emitted by the field emission electron beam source such that the emitted electrons heat the evaporation material such that it evaporates.

## Description

### Field of the invention

The present invention relates to an evaporation system comprising a field emission electron beam source.

### Description of the related art

Deposition methods are used to transfer a deposition material from a source to a substrate for forming a thin film or coating. Among the deposition methods, one of the most well known evaporation technique is electron beam evaporation, also known as e-beam evaporation. The deposition material is often comprised of metal, metallic or non metallic compounds, such as gold, silver, nickel chromium alloy, or silicon dioxide. Generally, the deposition material is placed in a crucible, and the substrate to be coated is placed at a fixed or variable distance from the crucible. A beam of electrons is directed onto the source material in the crucible, causing the deposition material to evaporate out of the crucible and adhere to the substrate. The process takes place inside a vacuum chamber.

The electron beam is generated by means of thermionic emission through heating a filament of refractory metals to above 2000 degrees Celsius. The electron beam is directed to the source material by an electromagnetic field. In practical operation, the evaporation is controlled by switching on/off of the heating power. It may take up to a few minutes to heat up the filament to a stable electron emission and the evaporation. The emission and the evaporation retain for a certain period of time even when the heating power is switched off. Therefore the operation cannot be performed in a swiftly pulsed mode, and the control of the deposition is carried out by switching a mechanical shutter. Thus, the evaporation starts long before the deposition starts (when the shutter is removed from above the substrate), and continue after the shutter is placed back above the substrate. Such a prolonged evaporation causes waste in source materials.

Generally, it is important to be able to control the coating purity and deposition delete thickness to achieve desired results. The accuracy of the thickness depends crucially on the relation between the evaporation rate and the switching on/off time of the evaporation/deposition, and the higher the evaporation rate, the faster the switching is required. Thus, it is highly desirable to shorten the time lag between the evaporation and the deposition to gain the control of the processes and save source materials.

Furthermore, many manufacturing steps involve depositing multilayered coatings of a multitude of materials. In addition, many of the benefits of producing multiple coating layers on a substrate are achieved when the coating steps are carried out sequentially under vacuum, and the trend in coating technology has been towards obtaining purer, more uniform and controllable coating thickness of multiple materials. Thus, for producing multiple coating layers a number of evaporation materials are loaded into a number of source pockets of a multi-pocket crucible, and the different pockets are in sequence moved into the fixed electron beam. An example of an evaporation system comprising such a multi-pocket crucible is disclosed in US 6,902,625, wherein the inactive pockets are covered by a lid for reducing cross-contamination between different pockets. However, the use of such a multi-pocket crucible is limiting and complicated, and reduces the efficiency of the evaporation system.

There is therefore a need for an evaporation system providing improved efficiency and reducing the latency between the evaporation of different evaporation materials.

### Summary of the invention

According to an aspect of the invention, the above object is met by an evaporation system, comprising a vacuum chamber, a crucible for receiving an evaporation material, a substrate holder for receiving a substrate, and an electron beam source for heating the evaporation material to be deposited on the substrate, wherein the electron beam source together with the crucible and the substrate holder are arranged inside of the vacuum chamber, wherein the electron beam source is a field emission electron beam source, and the evaporation system further comprises a control unit for controlling the direction of electrons emitted by the field emission electron beam source such that the emitted electrons heat the evaporation material, thereby evaporating the evaporating material under a fully controlled manner.

According to the invention, the electrons emitted by the field emission electron beam source, such as a cold cathode electrode source, causes the evaporation material, such as a metal, to evaporate in a direction towards the substrate such that the substrate is coated. By using a field emission electron beam source instead of a prior art electron beam source (e.g. "filament" electron beam source), it is possible to increase the efficiency of the evaporation system as it is possible to in a much higher degree control the electrons emitted by the field emission electron beam source in terms of switching time, current, kinetic energy and the direction such that the emitted electrons heat the evaporation material.

According to a preferred embodiment of the invention, the evaporation system further comprises a plurality of crucibles for receiving and containing different evaporation materials, and the strength and the direction of the electrons emitted by the field emission electron beam source is adjustable by the control unit, thereby allowing for subsequent heating of the different evaporation materials arranged in the plurality of crucibles without repositioning the crucibles, as the direction of the electrons instead is altered. This configuration allows for a multi-layer coating of the substrate in one duty cycle due to the fast switching possibility of the field emission electron beam source. In the case of multilayer deposition, a fast switching from one source material to another is beyond prior art. Thus, the present invention provides an advantage in relation to a prior art evaporation system due to its fast switching possibilities.

For the control of the electrons emitted by the field emission electron beam source the evaporation system may further comprise a control electrode for in cooperation with the control unit controlling the distribution of an electric field (i.e. the propagation of the electron beam) between the control electrode and the field emission electron beam source. Accordingly, the control electrode and the field emission electron beam source are arranged to cooperate such that the emitted electrons may be arrange to sequentially heat each of the different crucibles. The control electrode may for example be a ring electrode, a segmented ring electrode or a plurality of individual electron extraction electrodes. Preferably, the control electrode also cooperates with an electromagnet for directing the beam of electrons.

In a preferred embodiment, the evaporation system comprises a shutter which is controllable by the control unit, wherein the shutter is adapted to cover at least one of the substrate and the crucible. The shutter is preferably used in cooperation with a sensor for detecting the thickness of the evaporation material deposited onto the substrate. As soon as it is detected that the desired thickness is (more or less) reached, the shutter is moved in between the evaporated material and the substrate, thereby stopping the coating process. It is however, due to the high controllability of the field emission electron beam source, possible to quickly switch off the field emission electron beam source as the sensor detects an approach of the desired thickness, thus possibly eliminating the need for a shutter. Accordingly, it is possible to provide an efficient automatic coating of multiple evaporation materials. Additionally, the evaporation system may further comprise a cooling arrangement for the crucible, thereby allowing quick cooling of the evaporation material arrangement in the crucible. Water is a preferred cooling liquid, by other cooling methods are of course possible and within the scope of the present invention.

As mentioned above, the evaporation system comprises a vacuum chamber. This vacuum chamber should preferably provide a pressure between about 10⁻¹⁰ mPa to atmospheric pressure. However, the preferred pressure range is from 10⁻⁷ to 10⁻⁴ mPa during evaporation. In another preferred embodiment, the evaporation system further comprises a mixing chamber and means for introducing an oxidizing gas in the mixing chamber such that the oxidizing gas may be mixed with the evaporated material. However, this additional mixing gas should preferably only react with the evaporated material in the vicinity of the substrate, but not interfere with source materials in the crucible. This effect can be realized through nozzle ejection of the mixing gas near the substrate or differential pumping of the mixing chamber and the crucible chamber.

In an embodiment of the present invention, the field emission electron beam source comprises a conductive support and a carbonized solid compound foam at least partly covering the support, wherein the carbonized solid compound foam is transformed from a liquid compound comprising a phenolic resin and at least one of a metal salt and a metal oxide. The carbonized solid compound foam preferably has a continuous cellular structure, and further comprises a plurality of sharp emission edges arranged at the surface of the carbonized solid compound foam. Such a field emission electrode is for example disclose in European patent application EP05106440 and incorporated by reference.

In another embodiment, the field emission electron beam source comprises a plurality of ZnO nanostructures having a first end and a second end, an electrical insulation arranging to electrically insulate the ZnO nanostructures from each other, an electrical conductive member connected to the second end of a selection of the ZnO nanostructures, and a support structure arranged onto of the electrical conductive member, wherein the first end of the ZnO nanostructures are the end from which the ZnO nanostructures are allowed to grow from a well defined surface, and the first end of the ZnO nanostructures are exposed. Such a field emission electrode is for example disclosed in European patent application EP08150191 and also incorporated by reference.

According to a further aspect of the invention, there is provided an electron beam source for an evaporation system, the evaporation system comprising a vacuum chamber, a crucible for receiving an evaporation material, and a substrate holder for receiving a substrate, wherein the electron beam source is provided for heating the evaporation material to be deposited on the substrate, and the electron beam source together with the crucible and the substrate holder are arranged inside of the vacuum chamber, wherein the electron beam source is a field emission electron beam source, and the evaporation system further comprises a control unit for controlling of the electrons emitted by the field emission electron beam source in terms of switching time, current, kinetic energy and the direction such that the emitted electrons heat the evaporation material such that it evaporates in a fully controlled manner.

This aspect of the invention provides similar advantages as according to the above discussed evaporation system, including for example the possibility to increase the efficiency of the evaporation system as it is possible to in a much higher degree control the electrons emitted by the field emission electron beam source.

### Brief description of the drawings

These and other aspects of the present invention will now be described in more detail, with reference to the appended drawings showing currently preferred embodiments of the invention, in which:
Figure 1 is a conceptual overview of an evaporation system according to the present invention;
Figure 2a and 2b are different detailed conceptual views of field emission electron beam sources according to the invention in cooperation with control electrodes for example arranged in the evaporation system shown in figure 1;
Figure 3 is a multi-pocket crucible suitable for an evaporation system according to the present invention; and
Figure 4 is an alternative conceptual arrangement of an evaporation system according to the present invention.

### Detailed description of currently preferred embodiments

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled addressee. Like reference characters refer to like elements throughout.

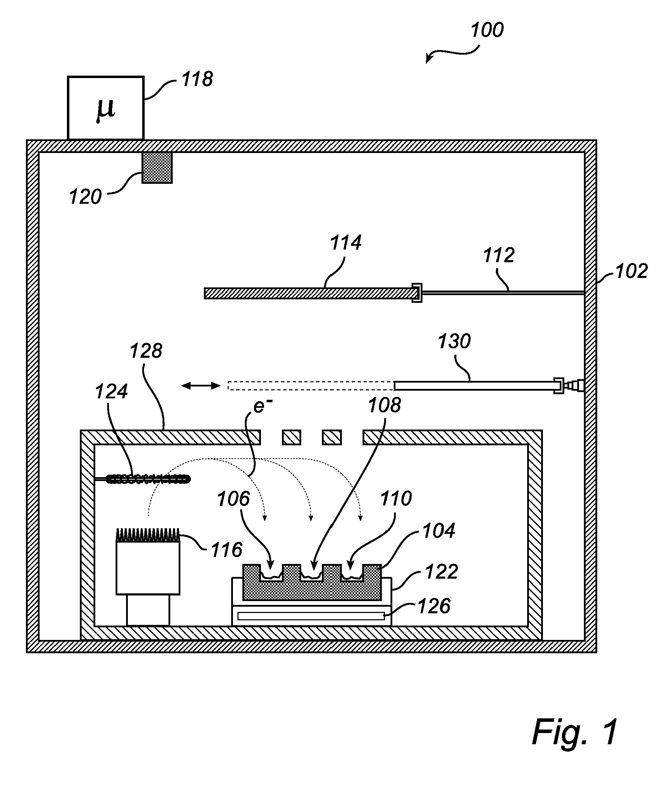

Referring now to the drawings and to figure 1 in particular, there is depicted an overview of an evaporation system 100 according to the present invention. The evaporation system 100 comprises a vacuum chamber 102, a multi-pocket crucible 104 for holding a plurality of different evaporation materials 106, 108, 110 (such for example including as gold, silver, copper, nickel and zinc delete), a substrate holder 112 for receiving a substrate 114, and a cold cathode field emission electron beam source 116 for sequentially heating the different evaporation materials 106, 108, 110 to be deposited on the substrate 114. It is noted from figure 1 that the field emission electron beam source 116 together with the multi-pocket crucible 104 and the substrate holder 112 holding the substrate 114 are arranged inside of the vacuum chamber 102, preferably providing a pressure range between about 10⁻⁷ to 10⁻⁴ mPa. The evaporation system 100 further comprises a control unit 118 for controlling the direction of electrons emitted by the field emission electron beam source 116 such that the emitted electrons sequentially heat the different evaporation materials 106, 108, 110 such that they evaporates. It should however be noted that not all of the evaporation materials 106, 108, 110 needs to be heated, i.e. only a single or only two of the evaporation materials may be heated at one time.

The system 100 further comprises a sensor 120 from monitoring the coating speed and/or the thickness of the evaporating materials 106, 108, 110 being deposited onto the substrate 114. The sensor 120 may for example be a piezoelectric sensor which changes its oscillating frequency as the thickness increases. Preferably, the sensor 120 is arranged at a distance equalling the distance from the crucible 104 to the substrate 114, or at least at a known distance within a circular arc coinciding with the positioning of the substrate 114. The circular arc could however be parallel to a circular arc relating to the substrate 114. Alternatively, it would be possible to use a RHEED (Reflection high-energy electron diffraction) system for characterizing the surface of the substrate 114 for determining the thickness of the deposited material.

In the illustrated embodiment, the multi-pocket crucible 104 is cooled by means of a water cooling arrangement 122, thereby providing additional control of the heating of the evaporation materials 106, 108, 110. The cooling arrangement is preferably controlled by means of the control unit 118, which also preferably receives thickness related information from the sensor 120. The skilled addressee understands that other cooling arrangements are possible, including for example cooling using liquid nitrogen.

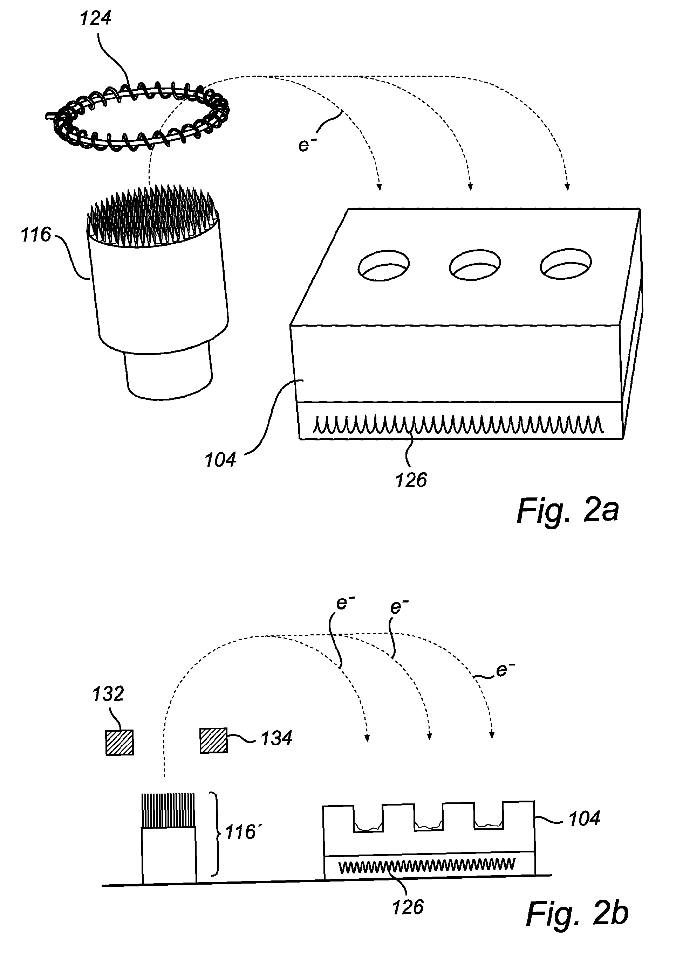

During operation of the evaporation system 100, an additional control electrode 124, or a plurality of control electrodes (e.g. two or more), cooperates with an electromagnet 126 for deflecting the electron beam transmitted from the field emission electron beam source towards the crucible 104. The detailed function of the above cooperation is further discussed below in relation to figure 2a and 2b. This control function, i.e. the deflection of the electron beam, is controlled by means of the control unit 118, which preferably further comprises a memory (not shown) for holding a control program for switching the direction of the electron beam such that each (or one) of the crucibles of the multi-pocket crucible 104 sequentially are heated, whereby an improved automated multilayered coating of the substrate 114 is made possible.

In the present embodiment as shown in figure 1, the evaporation system 100 further comprises a mixing chamber 128 and means for introducing a gas in the mixing chamber 128. The gas is preferably an oxidizing gas, such as oxygen, ozone or nitrous oxide. Other gases are of course possible and within the scope of the present invention. By mixing the oxidizing gas with the evaporated material (i.e. in the mixing chamber 128), it is possible to provide an oxidized evaporation material, such as for example NiO (e.g. evaporated nickel atoms oxidized by oxygen). The oxidized evaporation material 106, 108, 110 will as discussed above coat the substrate 114. The mixing chamber 128 will preferably be provided with means for performing for example a differential pumping, thereby not affecting the vacuum in the vacuum chamber 102. Accordingly, the evaporated species of the oxidized evaporation material are allowed to freely move in the vacuum chamber 102. Preferably, the pressure within the mixing chamber 128, P₁, is kept slightly higher than the pressure, P₂, within "the remaining" of the vacuum chamber 102, i.e. P₂ > P₁. An example of a system using a similar technique (i.e. differential pumping) is an MBE (Molecular Beam Epitaxy) system, which is disclosed by US 4,137,865 which is herein fully incorporated by reference.

Additionally, the evaporation system 100 comprises a shutter 130 which is controllable by the control unit 118. As mentioned above, the shutter 130 is preferably used in cooperation with the sensor 120. That is, as soon as it is detected that a desired thickness is reached, the shutter 130 is moved in between the evaporated material 106, 108, 100 and the substrate 114, thereby stopping the coating process.

Figure 2a provides a detailed conceptual illustration of an example of a field emission electron beam source 116 and its cooperation with a control electrode 124 according to an embodiment of the present invention. In the illustrated embodiment, the field emission electron beam source 116 is a field emission electron beam source as disclosed in the above mentioned European patent application EP05106440. By means of the manufacturing method disclosed in European patent application EP05106440, it is possible to achieve a low work function for the field emission electron beam source, thereby providing for an improved functionality of the evaporation system 100. The improved functionality is based on the sharp emission edges of the field emission electron beam source 116, which thereby increase the ease for electrons to "leave" the field emission electron beam source 116, lowering the necessary voltage field for extracting electrons from the outer surface of the field emission electron beam source 116.

In figure 2a, the ring electrode 124 is used for creating an electrical field. Thus, electrons are "extracted" from the field emission electron beam source 116, and accelerated in the direction of the ring electrode 124. However, an adjustable electromagnet (not shown in figure 2a) arrange below the crucible 104 will "steer" the electrons in a direction towards the evaporation material arranged in the crucible 104, such that a bent beam of electrons are transferred from the field emission electron beam source 116 to start the evaporation of the evaporation materials (i.e. by means of the magnetic field introduced by means of the electromagnet). As discussed above, the field emission electron beam source 116 preferably comprises a conductive support and a carbonized solid compound foam at least partly covering the support, wherein the carbonized solid compound foam is transformed from a liquid compound comprising a phenolic resin and at least one of a metal salt and a metal oxide. Also, the carbonized solid compound foam preferably has a continuous cellular structure, and further comprises a plurality of sharp emission edges arranged at the surface of the carbonized solid compound foam.

Turning now to figure 2b, which shows an other conceptual illustration of a different field emission electron beam source 116' and its cooperation with a plurality of control electrode (in the illustrated embodiment two) 132, 134 according to another embodiment of the present invention. In the illustrated embodiment, the field emission electron beam source 116' is a field emission electron beam source as disclosed in the above mentioned European patent application EP08150191. Similarly as discussed above, by means of the manufacturing method disclosed in European patent application EP05106440, it is possible to achieve an improved work function for the field emission electron beam source 116', thereby providing for an improved functionality of the evaporation system 100.

In figure 2b, the field emission electron beam source 116' is comprised of a plurality of ZnO nanostructures. The plurality of ZnO nanostructures also provides a plurality of sharp emission points, i.e. emission tips, by using grown out nanostructures. The nanostructures also provides prolonged lifetime and increased energy efficiency due to their individual alignment as it is possible to achieve a equal electron emission from each of the nanostructures. However, the basic functionality, i.e. the extraction of electrons by means of control electrodes, are similar to the functionality described in relation to figure 2a.

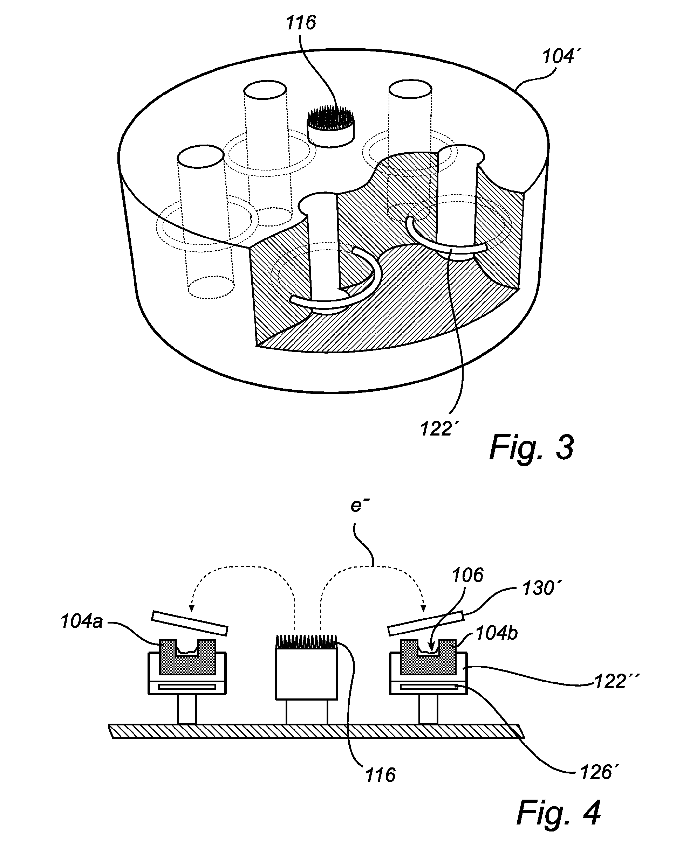

Moving on, figure 3 conceptually illustrates a multi-pocket crucible 104' suitable for an evaporation system according to the present invention. In the illustrated embodiment, the multi-pocket crucible 104' may hold up to five different evaporation materials. However, it is of course possible to arrange the multi-pocket crucible 104' to hold more or less crucibles. Furthermore, in the illustrated embodiment, each of the crucibles holds its own cooling arrangement 122', for example cooled by means of water or liquid nitrogen. The cooling arrangement is preferably controlled by the control unit 118, and controlled such that the contamination between the different crucibles is held to a minimum. Additionally, the field emission electron beam source 116 or 116' may be incorporated or embedded in the multi-pocket crucible 104' at a central position, thereby providing for equal distances between the different crucibles and the field emission electron beam source 116/116'.

Finally, in figure 4 there is illustrated an alternative conceptual arrangement of an evaporation system according to the present invention. In the illustrated embodiment, two single crucibles 104a and 104b are provided having similarly (individual) cooling arrangements 122" and (individual) electromagnets126'. Additionally, each of the single crucibles 104a and 104b are each provided with individual shutters 130'. In a similar manner as in the embodiment illustrated in figure 3, a field emission electron beam source 116 (or 116') is arranged centrally between the crucibles 104a and 104b, thus leading to an equal distance between the field emission electron beam source 116 and each of the crucibles 104a and 104b.

Furthermore, the skilled addressee realizes that the present invention by no means is limited to the preferred embodiments described above. On the contrary, many modifications and variations are possible within the scope of the appended claims. For example, it is of course possible to arrange the multi-pocket crucible 104 to hold more than three evaporation materials, such as four or more evaporation materials. The evaporation system 100 can also comprise an additional cooling and/or heating arrangement for cooling and/or heating the substrate 114. Additionally, instead of the oxidizing gas, a oxidizing agent may be introduced into the mixing chamber for providing an oxidized evaporation material by mixture with the evaporated material. It should also be noted that an arrangement according to the present invention could be arranged to "pre-heat" a single or multiple source crucible slightly below the evaporation temperature like in an MBE system, and then heat the crucible(s) by the field emission electron beam source to do evaporation, thereby forming a Field Emission Molecular Beam Epitaxy (FEMBE) system. Additionally, a preparation chamber may be included for introducing the substrates into the vacuum chamber, where the preparation chamber may be connected to the vacuum chamber by means of an air look valve. An illustration of such an arrangement is provided by the referenced US 4,137,865.

## Claims

1. An evaporation system, comprising:
- a vacuum chamber;
- a crucible for receiving an evaporation material;
- a substrate holder for receiving a substrate; and
- an electron beam source for heating the evaporation material to be deposited on the substrate, wherein the electron beam source together with the crucible and the substrate holder are arranged inside of the vacuum chamber, **characterized in that** the electron beam source is a field emission electron beam source, and that the evaporation system further comprises a control unit for controlling the direction of electrons emitted by the field emission electron beam source such that the emitted electrons heat the evaporation material such that it evaporates.

2. Evaporation system according to claim 1, further comprising a plurality of crucibles for receiving different evaporation materials, wherein the direction of the electrons emitted by the field emission electron beam source is adjustable by the control unit, thereby allowing for subsequent heating of the different evaporation materials arranged in the plurality of crucibles.

3. Evaporation system according to any one of claims 1 and 2, further comprising a control electrode for in cooperation with the control unit controlling the strength and direction of an electric field between the control anode and the field emission electron beam source.

4. Evaporation system according to any one of the preceding claims, further comprising a shutter controllable by the control unit, wherein the shutter is adapted to cover at least one of the substrate and the field emission electron beam source.

5. Evaporation system according to any one of the preceding claims, further comprising a sensor for detecting the thickness of the evaporation material deposited onto the substrate.

6. Evaporation system according to any one of the preceding claims, further comprising a cooling arrangement for the crucible.

7. Evaporation system according to any one of the preceding claims,
wherein the vacuum chamber provides a pressure range between about 10⁻⁷ to 10⁻⁴ mPa.

8. Evaporation system according to any one of the preceding claims, further comprising a mixing chamber and means for introducing an oxidizing gas in the mixing chamber, wherein the oxidizing gas is mixed with the evaporated evaporation material inside of the mixing chamber.

9. Evaporation system according to any one of the preceding claims,
wherein the field emission electron beam source comprises a conductive support and a carbonized solid compound foam at least partly covering the support, and wherein the carbonized solid compound foam is transformed from a liquid compound comprising a phenolic resin and at least one of a metal salt and a metal oxide.

10. Evaporation system according to claim 9, wherein the carbonized solid compound foam has a continuous cellular structure.

11. Evaporation system according to any of claims 9 or 10, wherein the carbonized solid compound foam further comprises a plurality of sharp emission edges arranged at the surface of the carbonized solid compound foam.

12. Evaporation system according to any of claims 1 - 8, wherein the field emission electron beam source comprises a plurality of ZnO nanostructures having a first end and a second end, an electrical insulation arranging to electrically insulate the ZnO nanostructures from each other, an electrical conductive member connected to the second end of a selection of the ZnO nanostructures, and a support structure arranged onto of the electrical conductive member, wherein the first end of the ZnO nanostructures are the end from which the ZnO nanostructures are allowed to grow from a well defined surface, and the first end of the ZnO nanostructures are exposed.

13. Evaporation system according to any one of the preceding claims,
wherein the crucible is a multi crucible assembly for receiving a plurality of evaporation materials.

14. Evaporation system according to any one of the preceding claims,
wherein the evaporation system is a Field Emission Molecular Beam Epitaxy (FEMBE) system.

15. An electron beam source for an evaporation system, the evaporation system comprising:
- a vacuum chamber;
- a crucible for receiving an evaporation material; and
- a substrate holder for receiving a substrate,
wherein the electron beam source is provided for heating the evaporation material to be deposited on the substrate, and the electron beam source together with the crucible and the substrate holder are arranged inside of the vacuum chamber, **characterized in that** the electron beam source is a field emission electron beam source, and that the evaporation system further comprises a control unit for controlling the direction of electrons emitted by the field emission electron beam source such that the emitted electrons heat the evaporation material such that it evaporates.
